# EUROPEAN PATENT APPLICATION

(11) **EP 2 444 530 A1**
(43) Date of publication of application: **25.04.2012**
(21) Application number: 10789388.5
(22) Date of filing: 07.06.2010
(51) Int. Cl.: C25D 7/06, B32B 15/01, C25D 5/12, H05K 1/09

(54) **COPPER FOIL AND A METHOD FOR PRODUCING SAME**

(30) Priority: 19.06.2009 JP 2009146046
(71) Applicant: JX Nippon Mining & Metals Corporation, Tokyo 100-8164 (JP)
(72) Inventor: KAMINAGA Kengo, Hitachi-city Ibaraki 317-0056 (JP)
(74) Representative: Hoarton, Lloyd Douglas Charles
(86) International application number: PCT/JP2010/059602
(87) International publication number: WO 2010/147013

(57) **Abstract**

A copper foil comprising a plated layer containing nickel and zinc on a copper foil made of an electrolytic copper foil or a rolled copper foil, and a chromium plated layer on the plated layer containing nickel and zinc, wherein the zinc in the plated layer containing nickel and zinc is made of zinc oxide and metal zinc, and the ratio of metal zinc in the zinc oxide and metal zinc is 50% or less. This invention relates to a copper foil for a flexible printed board formed with a polyimide-based resin layer and in particular provides a copper foil having superior adhesive strength between the copper foil and the polyimide-based resin layer, having acid resistance and tin plating solution resistance, having high peel strength, comprising favorable etching properties and gloss level, and suitable for use in a flexible printed board capable of achieving fine patterning of wiring.

## Description

### TECHNICAL FIELD

The present invention relates to a copper foil for a flexible printed board in which a polyimide-based resin layer is formed on the copper foil, and particularly relates to a copper foil having superior adhesive strength between the copper foil and the polyimide-based resin layer, possessing tin plating solution resistance, and suitable for use in a flexible printed board capable of achieving fine patterning of wiring.

### BACKGROUND ART

In late years, pursuant to the advance of the miniaturization and integration of semiconductor devices and parts such as various electronic chip parts to be mounted, even finer patterning of wiring is being demanded in printed wiring boards which are processed from flexible printed boards for mounting the foregoing parts.
Conventionally, an electrolytic copper foil in which its adhesiveness with resin is improved by performing roughening treatment has been used, but there were problems in that the etching properties of the copper foil were considerably impaired due to the foregoing roughening treatment, it was difficult to perform etching at a high aspect ratio, and sufficient fine patterning could not be achieved.

Thus, in order to meet the demands of fine patterning, so-called low profiling, namely lowering of roughness, of moderating the roughening treatment of the electrolytic copper foil has been proposed.
Nevertheless, the low profiling of the electrolytic copper foil entails a problem in that it causes the adhesion strength between the electrolytic copper foil and the insulating polyimide layer to deteriorate. Thus, although there are demands of high-level fine patterning, there was a problem in that the desired adhesive strength could not be maintained, and the wiring would become separated from the polyimide layer at the processing stage.

The characteristics required for achieving the sophisticated fine patterning of the copper foil are not limited to the foregoing adhesiveness with resin. For example, superior acid resistance, tin plating solution resistance and the like are also required.
As the recent trend, there is much interest in the adhesion with the polyimide-based resin layer, and there are numerous patent documents related to this issue (refer to Patent Documents 3, 4 and 5).

These patent documents do not take sufficient account of the in-plane variation regarding the tin plating solution resistance in light of mass production. When the present inventors closely examined the issues related to the tin plating solution resistance, it was discovered that, with the technologies described in these patent documents. for instance, there are problems in that the surface subject to surface treatment was partially eroded in the evaluation of LT-34 by Rohm and Haas Company, which is a commercially available tin plating solution, and the plating solution infiltrated between the resin and the copper foil, thereby causing the adhesion to deteriorate.
As described above, it cannot be said that a copper foil with favorable characteristics has been obtained unless the various problems, including the foregoing problem of the infiltration of the tin plating solution, are comprehensively resolved in a copper foil for a flexible printed board in which a polyimide-based resin layer is formed on the copper foil.

[Patent Document 1] Japanese Unexamined Patent Application Publication No. 2002-217507
[Patent Document 2] Japanese Unexamined Patent Application Publication No. S56-155592
[Patent Document 3] Japanese Unexamined Patent Application Publication No. 2005-344174
[Patent Document 4] Japanese Unexamined Patent Application Publication No. 2007-165674
[Patent Document 5] Japanese Unexamined Patent Application Publication No. 2007-7937

### SUMMARY OF THE INVENTION

The present invention was devised in view of the foregoing problems, and its object is to provide a copper foil having superior adhesiveness (normal peel strength, heat-resistant peel strength) between the copper foil and the polyimide-based resin layer, possessing tin plating solution resistance, and also capable of achieving the fine patterning of wiring.

Based on the above, the present invention provides:
1. A copper foil comprising a plated layer containing nickel and zinc on a copper foil made of an electrolytic copper foil or a rolled copper foil, and a chromium plated layer on the plated layer containing nickel and zinc, wherein the zinc in the plated layer containing nickel and zinc is in a zerovalent metallic state and a bivalent oxidation state, and the ratio of metal zinc in the total zinc content is 50% or less;
2. The copper foil according to paragraph 1 above, wherein the plated layer containing nickel and zinc is 50 to 1500 µg/dm² based on the total amount of nickel and zinc;
3. The copper foil according to paragraph 1 above, wherein the plated layer containing nickel and zinc is 100 to 1000 µg/dm² based on the total amount of nickel and zinc;
4. The copper foil according to any one of paragraphs 1 to 3 above, wherein the nickel ratio {nickel amount / (nickel amount + zinc amount)} in the plated layer containing nickel and zinc is 40 to 80 wt%;
5. The copper foil according to any one of paragraphs 1 to 4 above, further comprising a mixed system silane coupling agent layer of amino-based alkoxysilane and tetraalkoxysilane on an outermost layer including the chromium plated layer;
6. The copper foil according to any one of paragraphs 1 to 5 above, wherein the zinc amount of the outermost layer measured via XPS is not greater than a detection limit, or 2 at% or less, and the chromium amount of the outermost layer is 5 to 30 at%; and
7. The copper foil according to any one of paragraphs 1 to 5 above, wherein the zinc amount of the outermost layer measured via XPS is not greater than a detection limit, or 1 at% or less, and the chromium amount of the outermost layer is 8 to 30 at%.

The present invention yields superior effects of being able to provide a copper foil having superior adhesiveness (normal peel strength, heat-resistant peel strength) between the copper foil and the polyimide-based resin layer, possessing tin plating solution resistance, and also capable of achieving the fine patterning of wiring.

### DETAILED DESCRIPTION OF THE INVENTION

Generally, an electrolytic copper foil is manufactured as follows; specifically, a rotating metal cathode drum and an insoluble metal anode arranged at a position that is substantially the lower half of the cathode drum and which surrounds the periphery of the cathode drum are used, copper is electrodeposited on the cathode drum by flowing copper electrolyte between the cathode drum and the anode and additionally applying a potential therebetween, and, upon reaching a predetermined thickness, the copper that was electrodeposited on the cathode drum is separated so as to continuously produce a copper foil.
Moreover, a rolled copper foil is manufactured by repeatedly rolling and annealing an ingot, which was obtained by melting and casting, a plurality of times. The foregoing electrolytic copper foil and rolled copper foil are well-known materials as a copper foil for a flexible printed board, and the present invention can be applied to all of these copper foils.

The present invention is a copper foil comprising a plated layer containing nickel and zinc (hereinafter referred to as the "nickel-zinc plated layer") on a copper foil made of an electrolytic copper foil or a rolled copper foil, and a chromium plated layer on the nickel-zinc plated layer. As described above, a copper foil comprising these coating layers is well known. Nevertheless, the problem is that when tin plating is performed to such well-known copper foil, the tin plating solution would infiltrate between the polyimide-based resin layer and the copper foil and cause the peel strength of the copper foil to deteriorate.
If the surface subject to surface treatment is even partially eroded due to the high erosive nature of the tin plating solution, this may lead to the separation of the circuit, which is an extremely grave problem.

Conventionally, this kind of phenomenon and the cause thereof was unknown. Thus, no measures for resolving it were taken. Generally, the technique of forming a nickel-zinc plated layer on a copper foil made of an electrolytic copper foil or a rolled copper foil is being performed, but the present inventors discovered that the foregoing problem of the infiltration of the tin plating solution was caused by the nickel-zinc plated layer that is coated on the surface of the copper foil.
This nickel-zinc plated layer is not a simple alloy plated layer. Upon examining the chemical state of zinc in the nickel-zinc plated layer, it was discovered that the nickel-zinc plated layer is configured from zinc oxide and/or zinc hydroxide and metal zinc.

The ratio of zinc oxide and/or zinc hydroxide and metal zinc can be achieved by changing the nickel-zinc plating. The nickel-zinc plating conditions are shown below, and a person skilled in the art can perform the nickel-zinc plating within the presented range. But it goes without saying that it cannot be constantly achieved without the intent of adjusting the ratio of zinc oxide and/or zinc hydroxide and metal zinc. This is in reference to the discovery that the ratio of zerovalent metal zinc in the total zinc content configured from a zerovalent metallic state and a bivalent oxidation state is the direct cause of the occurrence of infiltration of the tin plating solution.

The present inventors discovered that the occurrence of infiltration of the tin plating solution can be inhibited by causing the chemical state of zinc in the nickel-zinc plated layer; that is, causing the ratio of metal zinc in the total zinc content to be 50% or less. In particular, the metal zinc ratio in the plated layer can be lowered by performing nickel-zinc plating in strong acid.
Although explained specifically in the following Examples, when the ratio of metal zinc exceeds 50%, it becomes difficult to inhibit the occurrence of infiltration of the tin plating solution. Accordingly, the ratio of metal zinc is caused to be 50% or less.

Here, this should be easy to understand, but this means that the existence of zinc as zinc oxide in the nickel-zinc plated layer is preferable for preventing the occurrence of infiltration of the tin plating solution. Although it is difficult to cause the chemical state of all zinc in the nickel-zinc plating to be zinc oxide, it is possible to reduce metal zinc as much as possible; it is possible to reduce metal zinc to roughly 10%, and even 5%.
Nevertheless, as shown in the following Examples, the effect of inhibiting the occurrence of infiltration of the tin plating solution by reducing metal zinc as much as possible does not mean that metal zinc needs to be reduced to the utmost limit. Thus, with respect to the nickel-zinc plating conditions, the chemical state of zinc of the present invention can be achieved by adjusting, within the scope of constant conditions, the ratio of metal zinc in the zinc oxide and/or zinc hydroxide and metal zinc to be 50% or less.

With the present invention, desirably, the nickel-zinc plated layer is 50 to 1500 µg/dm² based on the total amount of nickel and zinc, and the nickel-zinc plated layer is 100 to 1000 µg/dm² based on the total amount of nickel and zinc. The existence of a nickel-zinc plated layer is an essential requirement in the present invention.
The nickel-zinc plated layer only needs to be a normal amount, but if the amount of this plated layer is less than 50 µg/dm², then the overall effect of plating becomes lost, and consequently results in the deterioration of the normal peel strength, heat-resistant peel strength, chemical resistance, and tin plating resistance of the nickel-zinc plated layer.
Moreover, the nickel-zinc plated layer does not need to exist excessively. Even if the nickel-zinc plated layer exists excessively, the effect becomes saturated, and this merely results in increased costs. In this respect, the amount of the nickel-zinc plated layer is desirably capped at 1500 µg/dm².

In addition, with the present invention, desirably, the nickel ratio in the nickel-zinc plated layer is 40 to 80 wt%. If the nickel ratio is less than 40 wt%, the chemical resistance and heat resistance will deteriorate. Contrarily, if the nickel ratio exceeds 80 wt%, the etching properties (fine etching properties) upon forming the circuit will deteriorate, and, therefore, the nickel ratio in the nickel-zinc plated layer is desirably capped at 80 wt%.
Note that, when the nickel ratio exceeds 90 wt%, the heat resistance will deteriorate. The reason for this is considered to be as follows: specifically, as the nickel ratio increases, the zinc amount relatively decreases, and the heat resistance of zinc thereby decreases. Accordingly, it is desirable to decide the nickel ratio in consideration of the foregoing points.

In addition, the present invention additionally provides a copper foil comprising a plated layer containing nickel and zinc on a copper foil made of an electrolytic copper foil or a rolled copper foil, and a chromium plated layer on the plated layer containing nickel and zinc, which further comprises a mixed system silane coupling agent layer of amino-based alkoxysilane and tetraalkoxysilane on an outermost layer including the chromium plated layer.
Adhesion to various types of polyimide-based resin can be obtained based on this mixed system silane coupling agent layer of amino-based alkoxysilane and tetraalkoxysilane.

In addition, the present invention provides a copper foil in which the metal zinc amount of the outermost layer measured via XPS is 2 at% or less, and the chromium amount of the outermost layer is 5 to 30 at%, and a copper foil in which the metal zinc amount of the outermost layer measured via XPS is 1 at% or less, and the chromium amount of the outermost layer is 8 to 30 at%. When the zinc amount exceeds 2 at%, the normal peel strength will deteriorate, and it is desirable to use the foregoing numerical values as the upper limit.
Moreover, in order to achieve tin plating solution resistance, desirably, the metal zinc amount of the outermost layer is low as possible. 0% would be favorable if possible, but in reality metal zinc exists in amount of roughly 0.01 at%. The metal zinc amount of the outermost layer described above is effective for achieving tin plating solution resistance.

The outermost layer with the chromium plated layer formed thereon will obviously contain large amounts of chromium, but it also contains oxygen, carbon, nitrogen, nickel, copper, and zinc. A moderate amount of chromium and zinc is effective to improve the normal peel strength. The foregoing range shows such moderate amount.
Thus, the chromium amount is effective to improve the normal peel strength and there is no particular upper limit, but in terms of production the limit is 40%. Under normal circumstances, the chromium amount is desirably set between 5 and 30 at%. Moreover, the existence of chromium is also effective for achieving tin plating solution resistance, even though it is not as effective as the nickel-zinc plated layer.

The outermost layer with the chromium plated layer formed thereon is roughly several nm (2 to 3 nm) in terms of depth measured with XPS. As described above, the film thickness is so thin that it is extremely difficult to measure the film thickness, and thus, it is anticipated that the film is not necessarily a uniform film but has the existence of numerous minute holes.
Accordingly, the outermost layer does not necessarily contain chromium only, and it is considered that components of the nickel-zinc plated layer as its base are exposed through the holes. Thus, it is anticipated that the outermost layer contains chromium, zinc, nickel, copper, and their oxides.

Generally, it is desirable to use an electrolytic copper foil having a surface roughness (ten point height of irregularities) (Rz) of 2.5 µm or less, but there is no need to be particularly limited to these conditions. A roughened surface (matted surface) with minute irregularities and a glossy surface can both be applied to the copper foil of the present invention. Moreover, since a rolled copper foil has a smooth surface due to the characteristics of its production process, it can also be applied to the present invention.
Generally, high etching precision can be obtained by causing the surface roughness of the copper foil to be 1.5 µm or less, and even 1.0 µm or less. Specifically, in order to improve the etching precision, preferably, the surface roughness of the raw copper foil is reduced at its best. Normally, roughening treatment is not required.

From this perspective, a glossy surface of a rolled copper foil or an electrolytic copper foil is preferably used. Nevertheless, the roughened surface of the electrolytic copper foil can also be subject to the foregoing conditions; that is, to achieve a surface roughness of 1.5 µm or less, and, therefore, a roughened surface can also be used.
An electrolytic copper foil and a rolled copper foil are continuously produced and wrapped around a coil, and a copper foil obtained as described can be additionally subject to the electrochemical or chemical surface treatment or coating of resin of the present invention so that it can be used in a printed wiring board and so on.

The thickness of the copper foil needs to be 18 µm or less, and even 3 to 12 µm for use as high-density wiring, but the copper foil treatment of the present invention can be applied without limitation to the foregoing thickness, and can similarly be applied to ultra-thin foils or thick copper foils.
Although the nickel-zinc plating is used as the heat-resistant layer in the present invention, similar results as the present invention can be expected by adding cobalt, molybdenum, phosphorus, boron, tungsten and the like to the coating in which the chemical state of zinc has been controlled, and subsequently controlling the ratio thereof. These elements can be selected as needed according to the usage of the copper foil of the printed wiring board, and the present invention covers all of the above.

There is no particular limitation as the means for forming the polyimide resin layer, and, for example, polyamic acid varnish (mixture containing polyamic acid obtained by adding and polymerizing aromatic diamines and aromatic dianhydrides in a solution state) can be used as the raw material.
The polyamic acid varnish is applied on the electrolytic copper foil or the rolled copper foil of the present invention and subsequently dried to form a polyamic acid layer as the polyimide precursor layer. The obtained polyamic acid layer is heated to 300°C to 400°C under an inert atmosphere of nitrogen or the like and imidized to form a polyimide-based resin layer.
Although there is no particular limitation in the thickness of the polyimide-based resin layer, it is usually 10 to 50 µm. Moreover, conventional additives may be added to the polyamic acid varnish as needed. With a flexible printed board obtained as described above, it is possible to achieve favorable adhesive strength between the electrolytic copper foil or the rolled copper foil of the present invention and the polyimide-based resin layer.

An electrolytic copper foil or a rolled copper foil is used, and the nickel-zinc plated layer and the chromium plated layer of the present invention are formed on the electrolytic copper foil or the rolled copper foil. An example of the electrochemical processing liquid is shown below.
(Nickel-zinc plating solution composition and plating conditions 1 )
Ni: 10 to 40 g/L
Zn: 0.5 to 7 g/L
H₂SO₄: 2 to 20 g/L
Bath temperature: Normal temperature to 65°C
Current density Dk: 10 to 50 A/dm²
Plating time: 1 to 4 seconds
(Nickel- zinc plating solution composition and plating conditions 2)
Ni: 10 to 40 g/L
Zn: 0.5 to 20 g/L
pH: 3.0 to 4.0
Bath temperature: Normal temperature to 65°C
Current density Dk: 1 to 15 A/dm²
Plating time: 1 to 4 seconds
(Cobalt - molybdenum plating solution composition and plating conditions)
Co: 10 to 40 g/L
Mo: 10 to 40 g/L
pH: 4.0 to 5.0
Bath temperature: Normal temperature to 40°C
Current density Dk: 1 to 15 A/dm²
Plating time: 1 to 10 seconds

(Chromium plating solution composition and plating conditions)
Cr0₃: 200 to 250 g/L (250 g/L in Examples and Comparative Examples)
H₂S0₄: 2 to 3 g/L (2.5 g/L in Examples and Comparative Examples)
Bath temperature: 50 to 60°C (55°C in Examples and Comparative Examples) Conventional additives such as sodium bichromate, potassium dichromate, trivalent chromium salt, and sodium silicofluoride can be added to the plating solution as needed.
(Coupling agent composition)
Amino-based silane coupling agent: 0.2 to 1.2 vol%
y-aminopropyltrimethoxysilane, N-(β(aminoethyl) γ-aminopropyltrimethoxysilane, for example Tetraalkoxysilane: 0.2 to 0.6 vol%
TEOS (tetraethoxysilane), for example.

### [Test method]

(Resin composition)
Polyimide: Manufactured by Ube Industries (U varnish A, resin thickness: 30 µm)
(Peel strength test)
Normal peel strength: 180° peeling test of a copper foil having a width of 3mm and film thickness of 9 µm
Peel strength after aging: Peel strength measurement after aging at 150°C for 7 days
(Tin plating solution infiltration test)
Tin plating solution: LT-34 manufactured by Rohm and Haas
Measurement of erosion after dipping at 70°C for 5 minutes
(XPS analysis)
Measurement was performed using AXIS-HS manufactured by Kratos. Although XPS measurement was carried out while sputtering the material, the present invention focuses on the measurement value of the outermost surface of the material before sputtering.

### [Examples]

The Examples of the present invention are now explained. These Examples are merely illustrative, and the present invention shall in no way be limited thereby. That is, various modifications and other embodiments based on the technical spirit claimed in the claims shall be included in the present invention as a matter of course.
Note that Comparative Examples are also indicated for comparison with the present invention.

### (Example 1)

As the copper foil, a rolled copper foil of 18 um having a surface roughness of Rz 0.7 µm was used. This rolled copper foil was subject to degreasing and water washing treatment, and subsequently subject to acid cleaning/water washing treatment, and then plating was performed under the foregoing nickel-zinc plating conditions. Nickel-zinc plating was performed under the foregoing Ni-Zn plating conditions 1, a chromium plated layer was additionally formed under the foregoing conditions, and a mixed system silane coupling agent layer of an amino system and TEOS was additionally formed thereon. Consequently, the Ni amount was 65 µg/dm², the Zn amount was 60 µg/dm², the ratio of metal zinc in the total zinc content in the nickel-zinc plated layer was 45%, the Ni ratio in the nickel-zinc plated layer was 52 wt%, the zinc amount of the outermost layer measured with XPS was 1 at%, and the chromium amount of the outermost layer was 8 at%.

Using the copper foil produced as described, based on the foregoing conditions, the normal peel strength, the peel strength retention after aging, and the infiltration amount of the tin plating solution were measured the results are in Table 1.

**[Table 1]**

| | Base foil | Throughput | | Chemical of Zn | state Ni_Zn film | XPS results | | Peel strength | Aging retention | Infiltration |
|---|---|---|---|---|---|---|---|---|---|---|
| | | Ni amount | Zn amount | Metal zinc ratio | Ni ratio | Zn | Cr | | | |
| | | µg/dm² | µg/dm² | % | wt% | at% | at% | kN/m | % | µm |
| Example 1 | Rolled copper foil | 65 | 60 | 45 | 52 | 1 | 8 | 0.9 | >80 | <1 |
| Example 2 | Rolled copper foil | 80 | 65 | 40 | 55 | 1.2 | 9 | 0.9 | >80 | <1 |
| Example 3 | Electrolytic copper foil | 55 | 80 | 35 | 41 | 1.2 | 8 | 0.8 | >80 | <1 |
| Example 4 | Rolled foil copper foil | 220 | 300 | 12 | 42 | 1.9 | 8 | 0.7 | >80 | <1 |
| Example 5 | Rolled copper foil | 300 | 80 | 45 | 79 | 0.8 | 10 | 0.9 | >80 | <1 |
| Example 6 | Rolled copper foil | 110 | 110 | 40 | 50 | 0.1 | 23 | 1.3 | >80 | <1 |
| Example 7 | Rolled foil copper foil | 700 | 300 | 30 | 70 | 0.2 | 20 | 1.2 | >80 | <1 |
| Example 8 | Electrolytic copper foil | 650 | 350 | 20 | 65 | 1 | 20 | 1.2 | >80 | <1 |

As shown in Table 1, the normal peel strength was 0.9 kN/m, the peel strength retention after aging was >80%, and the infiltration amount of the tin plating solution was <1 µm.
With the foregoing test results of Example 1, the adhesiveness (normal peel strength, heat-resistant peel strength) with the polyimide-based resin layer and the tin plating solution resistance were both superior. Moreover, although not shown in the table, the etching properties were also superior.

### (Example 2)

As the copper foil, a rolled copper foil of 18 µm having a surface roughness of Rz 0.7 µm was used. This rolled copper foil was subject to degreasing and water washing treatment, and subsequently subject to acid cleaning/water washing treatment, and then plating was performed under the foregoing nickel-zinc plating conditions. Nickel-zinc plating was performed under the foregoing Ni-Zn plating conditions 1, a chromium plated layer was additionally formed under the foregoing conditions, and a mixed system silane coupling agent layer of an amino system and TEOS was additionally formed thereon. Consequently, the Ni amount was 80 µg/dm², the Zn amount was 65 µg/dm², the ratio of metal zinc in the total zinc content in the nickel-zinc plated layer was 40%, the Ni ratio in the nickel-zinc plated layer was 55 wt%, the zinc amount of the outermost layer measured with XPS was 1.2 at%, and the chromium amount of the outermost layer was 9 at%.

Using the copper foil produced as described, based on the foregoing conditions, the normal peel strength, the peel strength retention after aging, and the infiltration amount of the tin plating solution were measured; the results are in Table 1.
As shown in Table 1, the normal peel strength was 0.9 kN/m, the peel strength retention after aging was >80%, and the infiltration amount of the tin plating solution was <1 µm.
With the foregoing test results of Example 2, the adhesiveness (normal peel strength, heat-resistant peel strength) with the polyimide-based resin layer and the tin plating solution resistance were both superior. Moreover, although not shown in the table, the etching properties were also superior.

### (Example 3)

As the copper foil, an electrolytic copper foil of 18 µm having a surface roughness of Rz 0.7 µm was used. This electrolytic copper foil was subject to degreasing and water washing treatment, and subsequently subject to acid cleaning/water washing treatment, and then plating was performed under the foregoing nickel-zinc plating conditions. Nickel-zinc plating was performed under the foregoing Ni-Zn plating conditions 1, a chromium plated layer was additionally formed under the foregoing conditions, and a mixed system silane coupling agent layer of an amino system and TEOS was additionally formed thereon. Consequently, the Ni amount was 55 µg/dm², the Zn amount was 80 µg/dm², the ratio of metal zinc in the total zinc content in the nickel-zinc plated layer was 35%, the Ni ratio in the nickel-zinc plated layer was 41 wt%, the zinc amount of the outermost layer measured with XPS was 1.2 at%, and the chromium amount of the outermost layer was 8 at%.

A chromium plated layer was additionally formed on the copper foil that was subject to the nickel-zinc plating under the foregoing conditions, and a mixed system silane coupling agent layer of an amino system and TEOS was additionally formed thereon.
Using the copper foil produced as described, based on the foregoing conditions, the normal peel strength, the peel strength retention after aging, and the infiltration amount of the tin plating solution were measured; the results are in Table 1.
As shown in Table 1, the normal peel strength was 0.8 kN/m, the peel strength retention after aging was >80%, and the infiltration amount of the tin plating solution was <1 µm.
With the foregoing test results of Example 3, the adhesiveness (normal peel strength, heat-resistant peel strength) with the polyimide-based resin layer and the tin plating solution resistance were both superior. Moreover, although not shown in the table, the etching properties were also superior.

### (Example 4)

As the copper foil, a rolled copper foil of 18 µm having a surface roughness of Rz 0.7 µm was used. This rolled copper foil was subject to degreasing and water washing treatment, and subsequently subject to acid cleaning/water washing treatment, and then plating was performed under the foregoing nickel-zinc plating conditions. Nickel-zinc plating was performed under the foregoing Ni-Zn plating conditions 1, a chromium plated layer was additionally formed under the foregoing conditions, and a mixed system silane coupling agent layer of an amino system and TEOS was additionally formed thereon. Consequently, the Ni amount was 220 µg/dm², the Zn amount was 300 µg/dm², the ratio of metal zinc in the total zinc content in the nickel-zinc plated layer was 12%, the Ni ratio in the nickel-zinc plated layer was 42 wt%, the zinc amount of the outermost layer measured with XPS was 1.9 at%, and the chromium amount of the outermost layer was 8 at%.
Using the copper foil produced as described, based on the foregoing conditions, the normal peel strength, the peel strength retention after aging, and the infiltration amount of the tin plating solution were measured; the results are in Table 1.
As shown in Table 1, the normal peel strength was 0.7 kN/m, the peel strength retention after aging was >80%, and the infiltration amount of the tin plating solution was <1 µm.
With the foregoing test results of Example 4, the adhesiveness (normal peel strength, heat-resistant peel strength) with the polyimide-based resin layer and the tin plating solution resistance were both superior. Moreover, although not shown in the table, the etching properties were also superior.

### (Example 5)

As the copper foil, a rolled copper foil of 18 µm having a surface roughness of Rz 0.7 µm was used. This rolled copper foil was subject to degreasing and water washing treatment, and subsequently subject to acid cleaning/water washing treatment, and then plating was performed under the foregoing nickel-zinc plating conditions. Nickel-zinc plating was performed under the foregoing Ni-Zn plating conditions 1, a chromium plated layer was additionally formed under the foregoing conditions, and a mixed system silane coupling agent layer of an amino system and TEOS was additionally formed thereon. Consequently, the Ni amount was 300 µg/dm², the Zn amount was 80 µg/dm², the ratio of metal zinc in the total zinc content in the nickel-zinc plated layer was 45%, the Ni ratio in the nickel-zinc plated layer was 79 wt%, the zinc amount of the outermost layer measured with XPS was 0.8 at%, and the chromium amount of the outermost layer was 10 at%.

Using the copper foil produced as described, based on the foregoing conditions, the normal peel strength, the peel strength retention after aging, and the infiltration amount of the tin plating solution were measured; the results are in Table 1.
As shown in Table 1, the normal peel strength was 0.9 kN/m, the peel strength retention after aging was >80%, and the infiltration amount of the tin plating solution was <1 µm.
With the foregoing test results of Example 5, the adhesiveness (normal peel strength, heat-resistant peel strength) with the polyimide-based resin layer and the tin plating solution resistance were both superior. Moreover, although not shown in the table, the etching properties were also superior.

### (Example 6)

As the copper foil, a rolled copper foil of 18 µm having a surface roughness of Rz 0.7 µm was used. This rolled copper foil was subject to degreasing and water washing treatment, and subsequently subject to acid cleaning/water washing treatment, and then plating was performed under the foregoing nickel-zinc plating conditions. Nickel-zinc plating was performed under the foregoing Ni-Zn plating conditions 1, a chromium plated layer was additionally formed under the foregoing conditions, and a mixed system silane coupling agent layer of an amino system and TEOS was additionally formed thereon. Consequently, the Ni amount was 110 µg/dm², the Zn amount was 110 µg/dm², the ratio of metal zinc in the total zinc content in the nickel-zinc plated layer was 40%, the Ni ratio in the nickel-zinc plated layer was 50 wt%, the zinc amount of the outermost layer measured with XPS was 0.1 at%, and the chromium amount of the outermost layer was 23 at%.

Using the copper foil produced as described, based on the foregoing conditions, the normal peel strength, the peel strength retention after aging, and the infiltration amount of the tin plating solution were measured; the results are in Table 1.
As shown in Table 1, the normal peel strength was 1.3 kN/m, the peel strength retention after aging was >80%, and the infiltration amount of the tin plating solution was <1 µm.
With the foregoing test results of Example 6, the adhesiveness (normal peel strength, heat-resistant peel strength) with the polyimide-based resin layer and the tin plating solution resistance were both superior. Moreover, although not shown in the table, the etching properties were also superior.

### (Example 7)

As the copper foil, a rolled copper foil of 18 µm having a surface roughness of Rz 0.7 µm was used. This rolled copper foil was subject to degreasing and water washing treatment, and subsequently subject to acid cleaning/water washing treatment, and then plating was performed under the foregoing nickel-zinc plating conditions. Nickel-zinc plating was performed under the foregoing Ni-Zn plating conditions 1, a chromium plated layer was additionally formed under the foregoing conditions, and a mixed system silane coupling agent layer of an amino system and TEOS was additionally formed thereon. Consequently, the Ni amount was 700 µg/dm², the Zn amount was 300 µg/dm², the ratio of metal zinc in the total zinc content in the nickel-zinc plated layer was 30%, the Ni ratio in the nickel-zinc plated layer was 70 wt%, the zinc amount of the outermost layer measured with XPS was 0.2 at%, and the chromium amount of the outermost layer was 20 at%.

Using the copper foil produced as described, based on the foregoing conditions, the normal peel strength, the peel strength retention after aging, and the infiltration amount of the tin plating solution were measured; the results are in Table 1.
As shown in Table 1, the normal peel strength was 1.2 kN/m, the peel strength retention after aging was >80%, and the infiltration amount of the tin plating solution was <1 µm.
With the foregoing test results of Example 7, the adhesiveness (normal peel strength, heat-resistant peel strength) with the polyimide-based resin layer and the tin plating solution resistance were both superior. Moreover, although not shown in the table, the etching properties were also superior.

### (Example 8)

As the copper foil, an electrolytic copper foil of 18 µm having a surface roughness of Rz 0.7 µm was used. This electrolytic copper foil was subject to degreasing and water washing treatment, and subsequently subject to acid cleaning/water washing treatment, and then plating was performed under the foregoing nickel-zinc plating conditions. Nickel-zinc plating was performed under the foregoing Ni-Zn plating conditions 1, a chromium plated layer was additionally formed under the foregoing conditions, and a mixed system silane coupling agent layer of an amino system and TEOS was additionally formed thereon. Consequently, the Ni amount was 650 µg/dm², the Zn amount was 350 µg/dm², the ratio of metal zinc in the total zinc content in the nickel-zinc plated layer was 20%, the Ni ratio in the nickel-zinc plated layer was 65 wt%, the zinc amount of the outermost layer measured with XPS was 1 at%, and the chromium amount of the outermost layer was 20 at%.

Using the copper foil produced as described, based on the foregoing conditions, the normal peel strength, the peel strength retention after aging, and the infiltration amount of the tin plating solution were measured; the results are in Table 1.
In Table 1, the normal peel strength was 1.2 kN/m, the peel strength retention after aging was >80%, and the infiltration amount of the tin plating solution was <1 µm.
With the foregoing test results of Example 8, the adhesiveness (normal peel strength, heat-resistant peel strength) with the polyimide-based resin layer and the tin plating solution resistance were both superior. Moreover, although not shown in the table, the etching properties were also superior.

### (Comparative Example 1)

As the copper foil, a rolled copper foil of 18 µm having a surface roughness of Rz 0.7 µm was used. This rolled copper foil was subject to degreasing and water washing treatment, and subsequently subject to acid cleaning/water washing treatment, and then plating was performed under the foregoing nickel-zinc plating conditions. Nickel-zinc plating was performed under the foregoing Ni-Zn plating conditions 2, a chromium plated layer was additionally formed under the foregoing conditions, and a mixed system silane coupling agent layer of an amino system and TEOS was additionally formed thereon. Consequently, the Ni amount was 200 µg/dm², the Zn amount was 200 µg/dm², the ratio of metal zinc in the total zinc content in the nickel-zinc plated layer was 80%, the Ni ratio in the nickel-zinc plated layer was 50 wt%, the zinc amount of the outermost layer measured with XPS was 6 at%, and the chromium amount of the outermost layer was 2 at%.

Using the copper foil produced as described, based on the foregoing conditions, the normal peel strength, the peel strength retention after aging, and the infiltration amount of the tin plating solution were measured; the results are in Table 2.
As shown in Table 2, the normal peel strength was 0.2 kN/m, the peel strength retention after aging was >80%, and the infiltration amount of the tin plating solution was >2 µm.
With the foregoing test results of Comparative Example 1, the adhesiveness (normal peel strength, heat-resistant peel strength) with the polyimide-based resin layer and the tin plating solution resistance were both inferior.

**[Table 2]**

| | Base foil | Throughput | | Chemical state of Zn | Ni-Zn film | XPS results | | Peel strength | Aging retention | Infiltration |
|---|---|---|---|---|---|---|---|---|---|---|
| | | Ni amount | Zn amount | Metal zinc ratio | Ni ratio | Zn | Cr | | | |
| | | µg/dm² | µg/dm² | % | wt% | at% | at% | kN/m | % | µm |
| Comparative Example 1 | Rolled copper foil | 200 | 200 | 80 | 50 | 6 | 2 | 0.2 | >80 | >2 |
| Comparative Example 2 | Rolled copper foil | 200 | 0 | - | 100 | 0 | 3 | 0.7 | 40 | <1 |
| Comparative Example 3 | Electrolytic copper foil | 370 | 80 | 90 | 82 | 0.6 | 4 | 0.5 | >80 | >2 |
| Comparative Example 4 | Electrolytic copper foil | 200 | 20 | 70 | 91 | 0.3 | 3 | 0.3 | >80 | >2 |
| Comparative Example 5 | Electrolytic copper foil | Co amount | Mo amount | | | | | | | |
| | | 440 | 290 | _ | _ | 0 | 1 | 0.4 | >80 | >2 |

### (Comparative Example 2)

As the copper foil, a rolled copper foil of 18 µm having a surface roughness of Rz 0.7 µm was used. This rolled copper foil was subject to degreasing and water washing treatment, and subsequently subject to acid cleaning/water washing treatment, and then plating was performed under the foregoing nickel-zinc plating conditions. Nickel-zinc plating was performed under the foregoing Ni-Zn plating conditions 2, a chromium plated layer was additionally formed under the foregoing conditions, and a mixed system silane coupling agent layer of an amino system and TEOS was additionally formed thereon. Consequently, the Ni amount was 200 µg/dm², the Zn amount was 0 µg/dm², the ratio of metal zinc in the total zinc content in the nickel-zinc plated layer was - %, the Ni ratio in the nickel-zinc plated layer was 100 wt%, the zinc amount of the outermost layer measured with XPS was 0 at%, and the chromium amount of the outermost layer was 3 at%.

Using the copper foil produced as described, based on the foregoing conditions, the normal peel strength, the peel strength retention after aging, and the infiltration amount of the tin plating solution were measured; the results are in Table 2.
As shown in Table 2, the normal peel strength was 0.7 kN/m, the peel strength retention after aging was 40%, and the infiltration amount of the tin plating solution was <1 µm.
With the foregoing test results of Comparative Example 2, the adhesiveness (heat-resistant peel strength) with the polyimide-based resin layer was inferior.

### (Comparative Example 3)

As the copper foil, an electrolytic copper foil of 18 µm having a surface roughness of Rz 0.7 µm was used. This rolled copper foil was subject to degreasing and water washing treatment, and subsequently subject to acid cleaning/water washing treatment, and then plating was performed under the foregoing nickel-zinc plating conditions. Nickel-zinc plating was performed under the foregoing Ni-Zn plating conditions 2, a chromium plated layer was additionally formed under the foregoing conditions, and a mixed system silane coupling agent layer of an amino system and TEOS was additionally formed thereon. Consequently, the Ni amount was 370 µg/dm², the Zn amount was 80 µg/dm², the ratio of metal zinc in the total zinc content in the nickel-zinc plated layer was 90%, the Ni ratio in the nickel-zinc plated layer was 82 wt%, the zinc amount of the outermost layer measured with XPS was 0.6 at%, and the chromium amount of the outermost layer was 4 at%.

Using the copper foil produced as described, based on the foregoing conditions, the normal peel strength, the peel strength retention after aging, and the infiltration amount of the tin plating solution were measured; the results are in Table 2.
As shown in Table 2, the normal peel strength was 0.5 kN/m, the peel strength retention after aging was >80%, and the infiltration amount of the tin plating solution was >2 µm.
With the foregoing test results of Comparative Example 3, the adhesiveness (normal peel strength, heat-resistant peel strength) with the polyimide-based resin layer and the tin plating solution resistance were both inferior.

### (Comparative Example 4)

As the copper foil, an electrolytic copper foil of 18 µm having a surface roughness of Rz 0.7 µm was used. This electrolytic copper foil was subject to degreasing and water washing treatment, and subsequently subject to acid cleaning/water washing treatment, and then plating was performed under the foregoing nickel-zinc plating conditions. Nickel-zinc plating was performed under the foregoing Ni-Zn plating conditions 2, a chromium plated layer was additionally formed under the foregoing conditions, and a mixed system silane coupling agent layer of an amino system and TEOS was additionally formed thereon. Consequently, the Ni amount was 200 µg/dm², the Zn amount was 20 µg/dm², the ratio of metal zinc in the total zinc content in the nickel-zinc plated layer was 70%, the Ni ratio in the nickel-zinc plated layer was 91 wt%, the zinc amount of the outermost layer measured with XPS was 0.3 at%, and the chromium amount of the outermost layer was 3 at%.

Using the copper foil produced as described, based on the foregoing conditions, the normal peel strength, the peel strength retention after aging, and the infiltration amount of the tin plating solution were measured; the results are in Table 2.
As shown in Table 2, the normal peel strength was 0.3 kN/m, the peel strength retention after aging was >80%, and the infiltration amount of the tin plating solution was >2 µm.
With the foregoing test results of Comparative Example 4, the adhesiveness (normal peel strength, heat-resistant peel strength) with the polyimide-based resin layer and the tin plating solution resistance were both inferior.

### (Comparative Example 5)

As the copper foil, an electrolytic copper foil of 18 um having a surface roughness of Rz 0.7 µm was used. This electrolytic copper foil was subject to degreasing and water washing treatment, and subsequently subject to acid cleaning/water washing treatment, and then cobalt-molybdenum alloy plating was performed. Cobalt-molybdenum alloy plating was performed under the foregoing Co-Mo plating conditions, a chromium plated layer was additionally formed under the foregoing conditions, and a mixed system silane coupling agent layer of an amino system and TEOS was additionally formed thereon. Consequently, the Co amount was 440 µg/dm², the Mo amount was 290 µg/dm², and the chromium amount of the outermost layer measured with XPS was 1 at%.

Using the copper foil produced as described, based on the foregoing conditions, the normal peel strength, the peel strength retention after aging, and the infiltration amount of the tin plating solution were measured; the results are in Table 2.
As shown in Table 2, the normal peel strength was 0.4 kN/m, the peel strength retention after aging was >80%, and the infiltration amount of the tin plating solution was >2 µm.
With the foregoing test results of Comparative Example 5, the adhesiveness (normal peel strength, heat-resistant peel strength) with the polyimide-based resin layer and the tin plating solution resistance were both inferior.

### INDUSTRIAL APPLICABILITY

The present invention can provide a copper foil having superior adhesiveness (normal peel strength, heat-resistant peel strength) between the copper foil and the polyimide-based resin layer, possessing tin plating solution resistance, and also capable of achieving the fine patterning of wiring, and is useful as a copper foil for a flexible printed board for forming a polyimide-based resin layer.

## Claims

1. A copper foil comprising a plated layer containing nickel and zinc on a copper foil made of an electrolytic copper foil or a rolled copper foil, and a chromium plated layer on the plated layer containing nickel and zinc, wherein the zinc in the plated layer containing nickel and zinc is in a zerovalent metallic state and a bivalent oxidation state, and the ratio of zinc in a zerovalent metallic state relative to the total zinc content is 50% or less.

2. The copper foil according to claim 1, wherein the plated layer containing nickel and zinc is 50 to 1500 µg/dm² based on the total amount of nickel and zinc.

3. The copper foil according to claim 1, wherein the plated layer containing nickel and zinc is 100 to 1000 µg/dm² based on the total amount of nickel and zinc.

4. The copper foil according to any one of claims 1 to 3, wherein the nickel ratio {nickel amount / (nickel amount + zinc amount)} in the plated layer containing nickel and zinc is 40 to 80 wt%.

5. The copper foil according to any one of claims 1 to 4, further comprising a mixed system silane coupling agent layer of amino-based alkoxysilane and tetraalkoxysilane on an outermost layer including the chromium plated layer.

6. The copper foil according to any one of claims 1 to 5, wherein the zinc amount of the outermost layer measured via XPS is not greater than a detection limit, or 2 at% or less, and the chromium amount of the outermost layer is 5 to 30 at%.

7. The copper foil according to any one of claims 1 to 5, wherein the zinc amount of the outermost layer measured via XPS is not greater than a detection limit, or 1 at% or less, and the chromium amount of the outermost layer is 8 to 30 at%.
